# EUROPEAN PATENT APPLICATION

(11) **EP 0 552 547 A1**
(43) Date of publication of application: **28.07.1993**
(21) Application number: 92311298.1
(22) Date of filing: 10.12.1992
(51) Int. Cl.: C23C 16/26, C23C 16/50, H01J 37/02

(54) **Diamond films**

(30) Priority: 26.12.1991 US 813620
(71) Applicant: GENERAL ELECTRIC COMPANY, Schenectady, NY 12345 (US)
(72) Inventor: Savkar, Sudhir Dattatraya, Schenectady, New York 12309 (US); Miller, Russell Scott, Ballston Spa, New York 12020 (US)
(74) Representative: Pratt, Richard Wilson

(57) **Abstract**

This invention relates to an apparatus (4) and method for making large area diamond films using a high temperature plasma reactor with a plasma reactor stream flow controller (18) constructed of a non-carbonaceous refractive metal such as tungsten or rhenium where hydrocarbon injection is used. Such structures of this type generally allow large area diamond films to be created on a substrate in an efficient, cost-effective manner.

## Description

### Cross Reference to Related Applications

This application is related to commonly assigned U.S. Patent Application Serial No. 07/813,621 (RD-21,857), 07/813,622 (RD-21,856), 07/813,618 (RD-21,502), and 07/813,619 (RD-21,407) entitled "Apparatus and Method for Controlling the Formation of Diamond Films and Patterns Using Non-Carbonaceous Refractory Materials"; "Apparatus and Method for Making Large Area Diamond Films Using An Electro-Arc Technique"; "Apparatus and Method for Making Large Area Diamond Films Using Non-Carbonaceous Refractory Materials"; and "Apparatus and Method for Controlling the Formation of Large Area Diamond Films and Diamond Film Patterns".

### Background of the Invention

### Field of the Invention

This invention relates to an apparatus and method for making large area diamond films using a high temperature plasma reactor with plasma reactor stream flow controller constructed of a non-carbonaceous refractive metal such as tungsten or rhenium where hydrocarbon injection is used. Such structures of this type, generally, allow large area diamond films to be created on a substrate in an efficient, cost-effective manner.

### Description of the Related Art

It is known that the local temperature of the plasma of a high temperature plasma gun such as a DC torch or a radio frequency (RF) torch can reach as high as 8000°K and can be accurately measured by bare and sheathed tungsten/rhenium thermocouples. This technique was set forth by S.D. Savkar and R.S. Miller in a article entitled "RF Plasma Torch Temperature Field Measurements Using Thermocouples", 9th International Symposium on Plasma Chemistry, September, 1989. In this technique, thermocouples of tungsten/rhenium were formed into a rake and the rake was deployed within the plasma gun plume. Typically, tungsten melts at approximately 3500-3600°K. However, when the rake was placed in the plasma gun plume, the thermocouples did not melt. Basically, this is because tungsten is a refractory material and a good thermal radiator thus, the thermocouples exhibited an excellent balance between thermal radiation and thermal absorption. In short, the tungsten thermocouple in this case was able to rapidly cool itself as it was deployed in the gun plume. This cooling effect of the tungsten thermocouple allowed accurate measurements of the local temperature of the plasma to be performed, which, in turn, allowed the temperature of the gun plasma to be more accurately controlled. However, a more advantageous system, then, would be presented if other refractory materials which exhibit good thermal radiation techniques could be employed.

Presently, in the formation of diamond films, a DC torch is employed that has a diffuser attached. While this technique creates diamond films, these films do not achieve the desired size in surface area coverage. This is because, typically, the diffuser is constructed of copper and is water cooled. The diffuser must be constantly cooled in order to keep the diffuser from destructing due to the high temperatures of the plasma stream and this cooling adversely affects the deposition characteristics of the stream. Also, the stream must be recirculated within the diffuser in order to spread the stream flow out to create a diamond film. The spreading of the flow should create a large diamond film, but, typically, the recirculation of the flow traps the flow and a large area diamond film is not created. Finally, although the use of several diffusers placed side-by-side has been employed, a uniform large area diamond film was still difficult to achieve because the spacing between the diffusers created inconsistencies in the film thickness and an inordinate amount of skill by the artisan was required to attempt to alleviate this problem. Therefore, a still further advantageous system would be presented if refractory materials having good thermal radiation properties could be used which did not adversely affect the flow of the plasma stream but still created a large area diamond film.

It is apparent from the above that there exists a need in the art for a system which is capable of withstanding the high temperatures of a typical plasma stream, and which does not adversely affect the flow of the plasma stream, but which at the same times is capable of producing uniform, large area diamond films. It is a purpose of this invention to fulfill these and other needs in the art in a manner more apparent to the skilled artisan once given the following disclosure.

### Summary of the Invention

Generally speaking, this invention fulfills these needs by providing an apparatus for producing large area diamond films on a substrate, comprising a plasma gun means having a plasma stream, a hydrocarbon injection means located substantially adjacent said gun means and a plasma stream flow control means substantially constructed of a non-carbonaceous refractory material having high thermal radiation properties and substantially located between said gun means and said substrate.

In certain preferred embodiments, the plasma gun means are a DC torch or an RF torch. Also, the plasma stream flow control means is a grid, a nozzle or a basket-like structure constructed of tungsten or rhenium. Finally, the hydrocarbon injection means injects methane.

In another further preferred embodiment, the flow control means spreads out the plasma stream to create several secondary streams such that a diamond film is formed and the construction of the diffuser or the grid, the nozzle or the basket allows the plasma stream to be spread out over the substrate so that the diamond film is formed over a relatively large area of the substrate.

The preferred system, according to this invention, offers the following advantages: smaller sire, easy assembly; good economy; easy formation of larger area diamond films; good stability; excellent durability; and high strength for safety. In fact, in many of the preferred embodiments, these factors of ease of diamond film formation and durability are optimized to an extent considerably higher than heretofore achieved in prior, known diamond film formation systems.

### Brief Description of the Drawings

The above and other features of the present invention which will become more apparent as the description proceeds are best understood by considering the following detailed description in conjunction with the accompanying drawings wherein like characters represent like parts throughout the several views and in which:
Figure 1 is a graphical representation where a graphite rod monitors RF plasma temperatures and temperature (°K) is plotted against radial distance (mm) from the jet centerline;
Figure 2 is a schematic drawing of a RF plasma reactor with a grid, according to the present invention; and
Figure 3 is a schematic drawing of a RF plasma reactor with a basket, according to the present invention.

### Detailed Description of the Invention

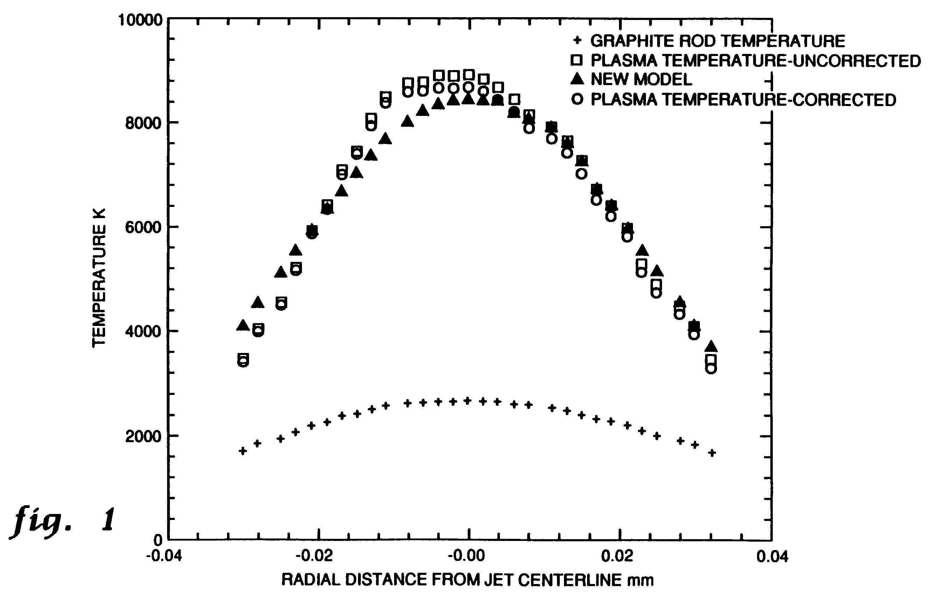

In order to more fully understand the nature of the process which is utilized to create large area diamond films, a brief background is presented. Carbon (C) and hydrogen (H₂) have a strong affinity over a wide range of temperatures and their chemistry plays an important role in the formation of diamond in the plasma jet or hot filament process. At the elevated plasma temperatures typically, around 8000°K, the hydrogen in the plasma reacts with graphite to strip off the carbon from the graphite, forming a variety of components such as CH, CH₂, CH₄, etc. These components then decompose, forming the diamond film on the suitably located and cooled substrate. Measurements show that the graphite or tungsten structure can basically survive in these plasmas so long as there is sufficient cooling for it, in the form of radiant sinks or internal (gas - helium or even liquid - water) cooling. The plasmas radiate relatively weakly in the mid-to-long wavelength infrared, permitting an unobstructed measurement of the infrared radiance of the graphite. Such measurements can be used to monitor the reaction and the quality of the product made. A sample set of temperature measurements for a 3.17 mm graphite rod inserted at a point 47.6 mm just below a RF torch operating with a mixture of 1/3 argon and 2/3 helium, at 250 torr, with torch (plate) power setting of about 67 KW are illustrated in Figure 1. The rod effectively cooled itself by radiation to the water cooled walls of the tank held at about 350°K. The underlying theory for this phenomena is the effective survivability of the graphite structure, suitably designed and suitably located in a plasma, provided the graphite has a low temperature sink it can radiate to. Plasma temperatures as high as 10000°K have been monitored in this way. It is to be understood that a tungsten rod would perform in much the same manner but methane must be added. In the latter case the presence of tungsten appears to aid in the process of forming atomic hydrogen from molecular hydrogen.

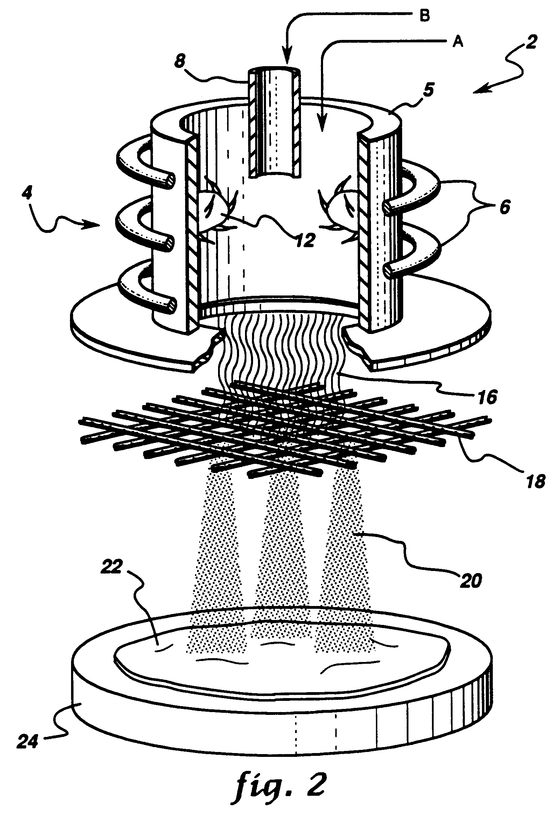

With reference to Figure 2, there is illustrated an apparatus 2 which creates a large area diamond film 22 on a substrate 24. In particular, apparatus 2 includes, in part, a conventional reactor 4. While reactor 4 is shown as a RF (inductively coupled) plasma reactor, other reactors such as a DC torch could be used. RF plasma reactor 4, typically, includes RF coils 6, fuel gas guide 8, injector 10 and RF fire ball 12. Fuel gas guide 8 allows fuel gas, such as a mixture of argon (Ar) ad hydrogen (H₂) to enter into reactor chamber 5 along the direction of arrow A. In the region between the fuel gas guide 8 and the reaction chamber 5, the sheath gas may be introduced along the direction of arrow B. The primary function of sheath gas is to help in the cooling of the walls of reactor chamber 5. Typically, hydrogen or hydrogen-rich mixtures are used for this purpose. Injector 10 introduces methane along the direction of arrow C into chamber 5. When fuel gas such as Ar, H₂, and methane if added to create the diamond sheets, are introduced into chamber 5, RF fireballs 12 are created according to well known RF plasma reactor techniques and a plasma stream 16 is created.

Located below reactor 4 is grid 18. Grid 18, preferably, is constructed of a refractive non-carbonaceous metal which exhibits high thermal radiation characteristics such as tungsten or rhenium. As discussed earlier, a refractive material is desired in the shape of grid 18 to spread out the flow of stream 16 to form a more uniform secondary flow 20 from which carbon is deposited on substrate 24 to create large area diamond film 22. It is to be understood that several apparatus 2 can be placed side-by-side (not shown) and a larger grid 18 employed in order to create an even larger film 22 on a very large substrate 24.

Substrate 24, preferably, is constructed of silicon or molybdenum. The proper selection of the substrate and its temperature is very important. The selection of the substrate temperature is a function of a number of parameters, including the amount of stresses built up in film 22. In general, a substrate temperature in excess of 700°K is preferred. The substrate temperature determines the amount of hydrogen left in film 22, in that, the higher the substrate temperature, the lower the retained hydrogen in the film. It is possible that the temperature may have to be as high as 1200-1300°K, especially if hydrogen free films are desired. There is clearly an upper bound to this temperature, because beyond a certain point, the graphitization of the deposited film is favored, not to mention the difficulty of operating with most substrate materials at such high temperatures.

It is to be understood that grid 18 can be moved up or down by a conventional movement means without affecting the level of hydrogen in the plasma. The water-cooled surface temperature of grid 18 may also be controlled by suitable choice of diameter, or by a conventional hollow rod (not shown), regardless of local plasma conditions. By so doing, the temperature at which primary reaction takes place and its kinetics can be changed at will. Likewise, the amount of hydrogen, especially atomic hydrogen, is thought to play an important role in forming diamond film 22. Indeed, the presence of atomic hydrogen impedes the formation of graphite under rapid quenching. The high temperatures of the thermal plasma insures that molecular hydrogen will be dissociated into atomic hydrogen over bulk of the plasma plume.

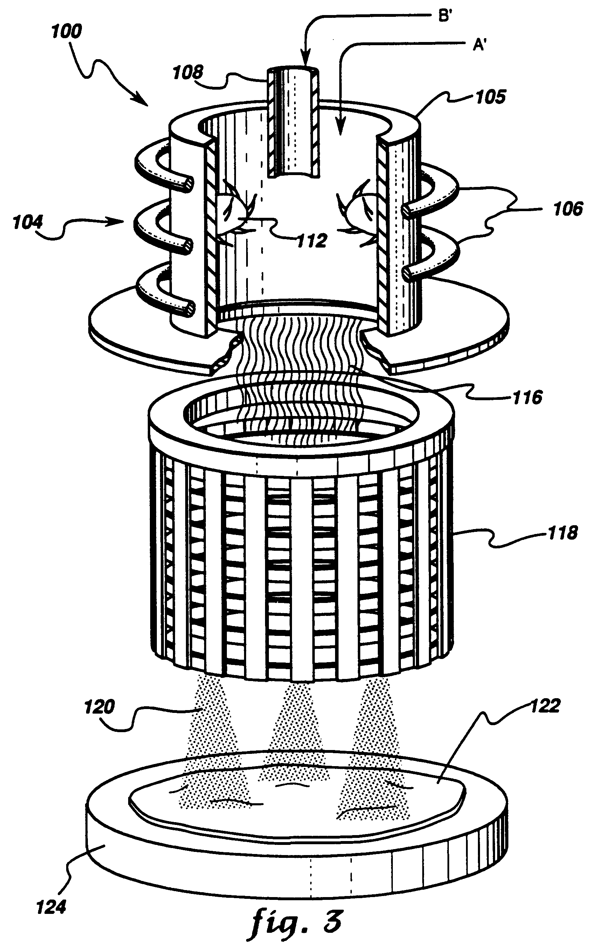

With respect to Figure 3, apparatus 100 for producing a large area diamond film 122 on substrate 124 is illustrated. Apparatus 100 is depicted in much the same construction as apparatus 2 (Figure 2). In particular, apparatus 100 includes, in part, a conventional reactor 104. While reactor 104 is shown as a RF plasma reactor, other reactors such as a DC torch could be used. RF plasma reactor 104, typically, includes RF coils 106, sheath 108, injector 110 and RF fireball 112. Sheath 108 allows sheath gas, such as a mixture of argon (Ar) and hydrogen (H₂) to enter into reactor chamber 105 along the direction of arrows A' and B'. Injector 110 introduces methane along the direction of arrow C' into chamber 105. When Ar, H₂ and methane are introduced into chamber 105, RF fireballs 112 are created according to well known RF plasma reactor techniques and a plasma stream 116 is created.

Located below reactor 104 is basket 118. Basket 118, preferably, is constructed of the same material as grid 18 (Figure 1). The material is formed in the shape of basket 118 in order to spread out the flow of stream 116 to form secondary flows 120 which is deposited on substrate 124 to create large area diamond film 122. Substrate 124, preferably, is constructed of the same material as substrate 24 (Figure 1).

In operation of the apparatus depicted in Figure 2 and 3, the diamond films 22 and 122, respectively, are generally formed in the same manner. In particular, the reactor (4 and 104, respectively) is activated to create the plasma stream (16 and 116, respectively). The stream contacts the non-carbonaceous refractive material (grid 18 in Figure 2 and basket 118 in Figure 4). Secondary flows (20 and 120, respectively) are created by refractive material and the flows are deposited on the substrate (24 and 124, respectively) to form large area diamond films (22 and 122, respectively). If desired, the substrates may be oscillated by a conventional oscillator in order to create the film shown in Figure 3.

Once given the above disclosure, many other features, modifications and improvements will become apparent to the skilled artisan. Such features, modifications and improvements are, therefore, considered to be a part of this invention, the scope of which is to be determined by the following claims.

## Claims

1. An apparatus for producing large area diamond films on a substrate, said apparatus comprised of:
a plasma gun means having a plasma stream;
a hydrocarbon injection means located substantially adjacent said gun means; and
a plasma stream flow control means substantially constructed of a non-carbonaceous refractory material having high thermal radiation properties and substantially located between said gun means and said substrate.

2. The apparatus, according to claim 1, wherein said substrate is further comprised of:
silicon.

3. The apparatus, according to claim 1 or claim 2, wherein said flow control means is further comprised of:
tungsten.

4. The apparatus, according to claim 1 or claim 2, wherein said flow control means is further comprised of:
refractive metal.

5. The apparatus, according to any preceding claim, wherein said plasma gun means is further comprised of:
a plasma torch means.

6. The apparatus, according to any preceding claim, wherein said flow control means is further comprised of:
a grid.

7. The apparatus, according to any one of claims 1 to 5, wherein said flow control means is further comprised of:
a basket.

8. The apparatus, according to any preceding claim, wherein said apparatus is further comprised of:
an oscillating means for oscillating said substrate.

9. A method for producing large area diamond films on a substrate having a plasma gun means emitting a plasma stream having a hydrocarbon injected therein and a plasma stream flow control means constructed of a non-carbonaceous refractory metal having high thermal radiation properties, wherein said method is comprised of the steps of:
activating said plasma gun means to create said plasma stream;
injecting said hydrocarbon into said plasma stream;
locating said flow control means within said plasma stream;
impinging said plasma stream on said flow control means;
increasing a surface area coverage of said plasma stream; and
depositing a diamond film on said substrate to create a large area diamond film.

10. The method, according to claim 9, wherein said method is further comprised of the step of:
oscillating said substrate.
